# EUROPEAN PATENT APPLICATION

(11) **EP 4 571 854 A1**
(43) Date of publication of application: **18.06.2025**
(21) Application number: 23852662.8
(22) Date of filing: 17.03.2023
(51) Int. Cl.: H01L 33/20, H01L 33/38, H01L 33/46, H01L 27/15, H01L 25/075, H01L 33/00

(54) **LIGHT-EMITTING ELEMENT, DISPLAY DEVICE COMPRISING SAME, AND METHOD FOR MANUFACTURING DISPLAY DEVICE**

(30) Priority: 10.08.2022 KR 20220100142
(71) Applicant: Samsung Display Co., Ltd., Gyeonggi-do 17113 (KR)
(72) Inventor: PARK, Ji Eun, Yongin-si, Gyeonggi-do 17113 (KR); KONG, Tae Jin, Yongin-si, Gyeonggi-do 17113 (KR); KIM, Myeong Hee, Yongin-si, Gyeonggi-do 17113 (KR); KIM, Seul Ki, Yongin-si, Gyeonggi-do 17113 (KR); SO, Myeong Su, Yongin-si, Gyeonggi-do 17113 (KR)
(74) Representative: Marks & Clerk LLP
(86) International application number: PCT/KR2023/003589
(87) International publication number: WO 2024/034765

(57) **Abstract**

A light emitting element includes a first end surface and a second end surface opposite to each other, the light emitting element includes: a first semiconductor layer disposed at the first end surface; an active layer disposed on the first semiconductor layer; a second semiconductor layer disposed on the active layer; and an electrode layer disposed on the second semiconductor layer and disposed at the second end surface. The first semiconductor layer includes a first part, a second part disposed on the first part and adjacent to the active layer, and a third part disposed between the first part and the second part. A width of the first part and a width of the second part are different from each other, and the third part has different widths at different length positions.

## Description

### Technical Field

The disclosure relates to a light emitting element, a display device including the light emitting element, and a method of fabricating the display device including the light emitting element.

### Background Art

Recently, as interest in information displays is increased, research and development of display devices have been continuously conducted.

### Detailed Description of Invention

### Technical Problem

Embodiments provide a light emitting element, a display device including the light emitting element, and a method of fabricating the display device including the light emitting element, which improve light emission efficiency.

However, embodiments of the disclosure are not limited to those set forth herein. The above and other embodiments will become more apparent to one of ordinary skill in the art to which the disclosure pertains by referencing the detailed description of the disclosure given below.

### Technical Solution

In an embodiment, a light emitting element may include: a first end surface and a second end surface opposite to each other; a first semiconductor layer disposed at the first end surface; an active layer disposed on the first semiconductor layer; a second semiconductor layer disposed on the active layer; and an electrode layer disposed on the second semiconductor layer and disposed at the second end surface, wherein the first semiconductor layer may include a first part, a second part disposed on the first part and adjacent to the active layer, and a third part disposed between the first part and the second part, a width of the first part and a width of the second part may be different from each other, and the third part may have different widths at different length positions.

Each of the first part and the second part of the first semiconductor layer may have a cylindrical pillar shape. The width of the second part may be greater than the width of the first part.

The width of the third part may increase as becoming closer to the second part from the first part.

The third part of the first semiconductor layer may have a truncated cone shape.

A side surface of the third part may have a slope at an angle with respect to the first end surface of the light emitting element.

The angle may be in a range of about 120 degrees or more.

Each of the active layer, the second semiconductor layer, and the electrode layer may have a cylindrical pillar shape.

A width of the active layer, a width of the second semiconductor layer, a width of the electrode layer, and the width of the second part of the first semiconductor layer may be substantially same as each other.

The light emitting element may further include a reflective layer surrounding a side surface of the first semiconductor layer, a side surface of the active layer, a side surface of the second semiconductor layer, and a side surface of the electrode layer.

The reflective layer may include a reflective metal material.

The light emitting element may further include an insulative film surrounding a side surface of the first semiconductor layer, a side surface of the active layer, a side surface of the second semiconductor layer, and a side surface of the electrode layer.

The insulative film may expose the first end surface of the light emitting element as a lower surface of the first semiconductor layer, and may expose the second end surface of the light emitting element as an upper surface of the electrode layer.

In an embodiment, a display device may include: a pixel including a first electrode, a second electrode, and a light emitting element including a first end surface electrically connected to the first electrode and a second end surface electrically connected to the second electrode, wherein the light emitting element may include: a first semiconductor layer disposed at the first end surface; an active layer disposed on the first semiconductor layer; a second semiconductor layer disposed on the active layer; and an electrode layer disposed on the second semiconductor layer and disposed at the second end surface, wherein the first semiconductor layer may include a first part, a second part disposed on the first part and adjacent to the active layer, and a third part disposed between the first part and the second part, a width of the first part and a width of the second part may be different from each other, and the third part may have different widths at different length positions.

Each of the first part and the second part may have a shape of a cylindrical pillar. The width of the second part may be greater than the width of the first part.

The width of the third part may increase as becoming closer to the second part from the first part.

In an embodiment, a method of fabricating a light emitting element may include: forming a pattern mask on a first substrate; sequentially forming a first semiconductor layer, an active layer, a second semiconductor layer, and an electrode layer on the first substrate on which a pattern mask is formed; sequentially forming a mask layer and an etching pattern layer on the electrode layer; forming a first light emitting stack member by patterning at least a portion of each of the first semiconductor layer, the active layer, the second semiconductor layer, and the electrode layer in a direction facing the first semiconductor layer from the electrode layer by a first etching process by using the mask layer and the etching pattern layer; separating the first light emitting stack member from the first substrate; forming a second light emitting stack member by patterning a side surface of the first semiconductor layer, a side surface of the active layer, a side surface of the second semiconductor layer, and a side surface of the electrode layer in a direction facing the electrode layer from the first semiconductor layer by a second etching process of patterning at least a portion of the first light emitting stack member; and attaching the second light emitting stack member to a second substrate.

The forming of the second light emitting stack member may include etching the first semiconductor layer such that at least a portion of the first semiconductor layer may have different widths at different length positions.

The method may further include forming a reflective layer on the side surface of the first semiconductor layer, the side surface of the active layer, the side surface of the second semiconductor layer, and the side surface of the electrode layer of the second light emitting stack member.

The method may further include forming an insulative film on the side surface of the first semiconductor layer, the side surface of the active layer, the side surface of the second semiconductor layer, and the side surface of the electrode layer of the second light emitting stack member.

The first etching process may be a dry etching process, and the second etching process may be a wet etching process.

### Advantageous Effects

In accordance with the embodiments, the light emitting element may have different widths with respect to areas and/or parts. For example, the first semiconductor layer included in the light emitting element may include a first part, a second part, and a third part between the first part and the second part, and the third part may have an inverted truncated cone shape.

A side surface of the third part may have a certain angle with respect to a surface (e.g., an upper surface and/or a lower surface) corresponding to end portions of the light emitting element, so that light generated from the active layer included in the light emitting element may be guided in the light emission direction. Accordingly, the light emission efficiency of the light emitting element may be improved.

However, the effects of the present invention are not limited to the effects described above, and may be expanded in various ways without departing from the spirit and scope of the present invention.

### Description of Drawings

FIG. 1 is a schematic perspective view illustrating a light emitting element in accordance with embodiments.
FIG. 2 is a schematic sectional view illustrating the light emitting element.
FIG. 3A is a schematic view illustrating light emission efficiency of a light emitting element in accordance with a comparative example.
FIG. 3B is a schematic view illustrating light emission efficiency of the light emitting element shown in FIG. 2.
FIGS. 4, 5, 6, 7, 8, 9, 10, 11, 12, 13, 14, and 15 are schematic sectional views illustrating a method of fabricating a light emitting element in accordance with embodiments.
FIG. 16 is a schematic plan view illustrating a display device in accordance with embodiments.
FIG. 17 is a schematic sectional view taken along line I-I' shown in FIG. 16.

### Modes of the Invention

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the X, Y, and Z - axes, and may be interpreted in a broader sense. For example, the DR1-axis, the DR2-axis, and the DR3-axis may be perpendicular to one another, or may represent different directions that are not perpendicular to one another. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another. For the purposes of this disclosure, "at least one of A and B" may be construed as understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Hereinafter, embodiments will be described in more detail with reference to the accompanying drawings. Throughout the drawings, the same reference numerals are given to the same elements, and their overlapping descriptions will be omitted.

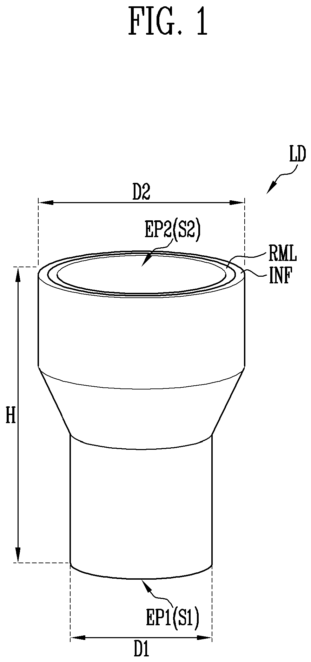

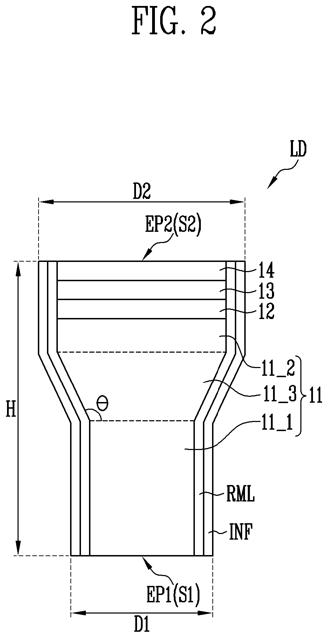

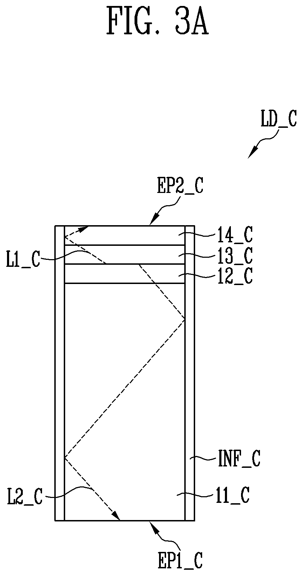

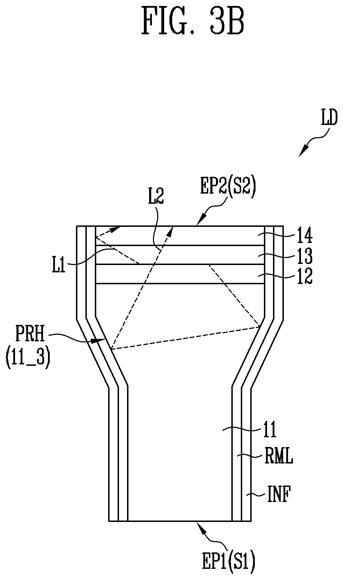

FIG. 1 is a schematic perspective view illustrating a light emitting element in accordance with an embodiment. FIG. 2 is a schematic sectional view illustrating the light emitting element. FIG. 3A is a schematic view illustrating light emission efficiency of a light emitting element in accordance with a comparative example. FIG. 3B is a schematic view illustrating light emission efficiency of the light emitting element shown in FIG. 2.

Referring to FIGS. 1 and 2, the light emitting element LD may include a first semiconductor layer 11, an active layer 12, a second semiconductor layer 13, and an electrode layer 14, which are sequentially disposed and/or stacked along a direction (e.g., a length H direction or a thickness direction). In an embodiment, the light emitting element LD may further include at least another semiconductor layer (e.g., at least another semiconductor layer disposed on the top surface (e.g., upper surface) and/or the bottom surface (e.g., lower surface) of the active layer 12).

The light emitting element LD may have a size in a range of nanometer scale to micrometer scale. For example, the light emitting element LD may have diameters D1 and D2 (or a width of a cross-section) and/or a length H in a range of nanometer to micrometer.

However, this is merely illustrative, and the structure, shape, size, and/or kind of the light emitting element LD may be changed in some embodiments. For example, the structure, shape, size, and/or kind of the light emitting element LD may be variously changed according to a design condition of a light emitting device using the light emitting element LD, light emitting characteristics to be secured, or the like.

In an embodiment, the light emitting element LD may be provided in a form in which the light emitting element LD has a rod shape. In description of the embodiment, the rod shape may include various forms of rod-like shape or bar-like shape, including a circular pillar shape, a polygonal pillar shape, a truncated cone shape, a truncated polypyramid shape, and the like, and the shape of a section of the rod shape is not limited. In an embodiment, the length H of the light emitting element LD may be greater than the diameters D1 and D2 (or the width of the cross-section) of the light emitting element LD.

The light emitting element LD may include a first end portion EP1 and a second end portion EP2, which face each other. For example, the light emitting element LD may include the first end portion EP1 and the second end portion EP2 at end portions (e.g., opposite end portions) thereof in the length H direction (or the thickness direction). The first end portion EP1 of the light emitting element LD may include a first end surface S1 (e.g., a lower surface) of the light emitting element LD and/or a peripheral area thereof. The second end portion EP2 of the light emitting element LD may include a second end surface S2 (e.g., an upper surface) of the light emitting element LD and/or a peripheral area thereof. The first end surface S1 and the second end surface S2 may be opposite to each other and may face each other.

For convenience of description, hereinafter, a surface corresponding to the first end portion EP1 is defined as the first end surface S1 (e.g., the lower surface) of the light emitting element LD, and a surface corresponding to the second end portion EP2 is defined as the second end surface S2 (e.g., the upper surface) of the light emitting element LD.

In an embodiment, the light emitting element LD may have different widths with respect to areas and/or parts thereof. For example, a diameter (e.g., a first diameter D1) of the first end surface S1 corresponding to the first end portion EP1 of the light emitting element LD and a diameter (e.g., a second diameter D2) of the second end surface corresponding to the second end portion EP2 of the light emitting element LD may be different from each other. For example, the second diameter D2 may be greater than the first diameter D1. For example, an area of the second end surface S2 (e.g., the upper surface) corresponding to the second end portion EP2 of the light emitting element LD may be greater than an area of the first end surface S1 (e.g., the lower surface) corresponding to the first end portion EP1 of the light emitting element LD.

For example, an intermediate area and/or an intermediate portion between the first end portion EP1 and the second end portion EP2 of the light emitting element LD may have a truncated cone shape. For example, the intermediate area and/or the intermediate portion of the light emitting element LD may have a diameter and a cross-section, which become larger (or increase) as becoming closer to the top thereof. For example, the intermediate area and/or the intermediate portion of the light emitting element LD may have an inverted truncated cone shape. The light emission efficiency of the light emitting element LD may be improved according to the shape (or form) of the light emitting element LD. The light emission efficiency according to the shape (or form) of the light emitting element LD will be described in more detail with reference to FIGS. 3A and 3B.

In an embodiment, the first semiconductor layer 11, the active layer 12, the second semiconductor layer 13, and the electrode layer 14 may be sequentially disposed in a direction from the first end portion EP1 to the second end portion EP2 of the light emitting element LD. For example, the first semiconductor layer 11 may be disposed at the first end portion EP1 of the light emitting element LD, and the electrode layer 14 may be disposed at the second end portion EP2 of the light emitting element LD. However, this is merely illustrative, and embodiments are not limited thereto. For example, the first semiconductor layer 11, the active layer 12, the second semiconductor layer 13, and the electrode layer 14 may be sequentially disposed in a direction from the second end portion EP2 to the first end portion EP1 of the light emitting element LD.

The first semiconductor layer 11 may include a first conductivity type semiconductor layer including a first conductivity type dopant. For example, the first semiconductor layer 11 may include an N-type semiconductor layer including an N-type dopant.

In an embodiment, the first semiconductor layer 11 may include a nitride-based semiconductor material or a phosphide-based semiconductor material. In an example, the first semiconductor layer 11 may include a nitride-based semiconductor material including at least one material among GaN, AlGaN, InGaN, AlInGaN, AlN, and InN, or a phosphide-based semiconductor material including at least one material among GaP, GaInP, AlGaP, AlGaInP, AlP, and InP. In an embodiment, the first semiconductor layer 11 may include an N-type dopant such as Si, Ge or Sn. However, this is merely illustrative, and the material of the first semiconductor layer 11 is not limited thereto. For example, the first semiconductor layer 11 may be formed of various materials.

The active layer 12 (or light emitting layer) may be disposed on the first semiconductor layer 11. The active layer 12 may include a single-quantum well structure or a multi-quantum well structure. In the case that a voltage which is a threshold voltage or higher is applied to end portions (e.g., opposite end portions) of the light emitting element LD, light may be emitted in the case that electron-hole pairs are combined in the active layer 12. In some embodiments, the position of the active layer 12 may be variously changed according to the kind of the light emitting element LD.

In an embodiment, the active layer 12 may emit light having a visible light wavelength band, e.g., light having a wavelength of about 400 nm to about 900 nm. For example, the active layer 12 may emit blue light, which has a wavelength in a range of about 450 nm to about 480 nm, green light, which has a wavelength in a range of about 480 nm to about 500 nm, or red light, which has a wavelength in a range of about 620 nm to about 750 nm. However, this is merely illustrative. For example, the color and/or wavelength band of light generated in the active layer 12 may be variously changed.

In an embodiment, the active layer 12 may include a nitride-based semiconductor material or a phosphide-based semiconductor material. In an example, the active layer 12 may include a nitride-based semiconductor material including at least one material among GaN, AlGaN, InGaN, InGaAlN, AlN, InN, and AlInN, or a phosphide-based semiconductor material including at least one material among GaP, GaInP, AlGaP, AlGaInP, AlP, and InP. However, this is merely illustrative, and the material of the active layer 12 is not limited thereto. For example, the active layer 12 may be formed of various materials.

In an embodiment, the active layer 12 may include an element involved in a color (or wavelength band) of light, and the color of light generated in the active layer 12 may be controlled by adjusting a content and/or a composition ratio of the element. In an embodiment, the active layer 12 may be formed as a multi-layer having a structure in which a GaN layer and an InGaN layer are alternately and/or repeatedly stacked, and emit light of a specific color according to a content and/or a composition ratio of indium (In) included in the InGaN layer. Thus, the light emitting element LD of a certain color may be fabricated by adjusting the content and/or the composition ratio of indium (In) included in the active layer 12.

The second semiconductor layer 13 may be disposed on the active layer 12. The second semiconductor layer 13 may include a second conductivity type semiconductor layer including a second conductivity type dopant. For example, the second semiconductor layer 13 may be a P-type semiconductor layer including a P-type dopant.

In an embodiment, the second semiconductor layer 13 may include a nitride-based semiconductor material or a phosphide-based semiconductor material. In an example, the second semiconductor layer 13 may include a nitride-based semiconductor material including at least one material among GaN, AlGaN, InGaN, AlInGaN, AlN, and InN, or a phosphide-based semiconductor material including at least one material among GaP, GaInP, AlGaP, AlGaInP, AlP, and InP. In an embodiment, the second semiconductor layer 13 may include a P-type dopant such as Mg. However, this is merely illustrative, and the material of the second semiconductor layer 13 is not limited thereto. For example, the second semiconductor layer 13 may be formed of various materials.

In an embodiment, the first semiconductor layer 11 and the second semiconductor layer 13 may include the same semiconductor material, and may include dopants of different conductivity types. In another example, the first semiconductor layer 11 and the second semiconductor layer 13 may include different semiconductor materials, and may include dopants of different conductivity types.

In an embodiment, the first semiconductor layer 11 and the second semiconductor layer 13 may have different length (or different thicknesses) in the length H direction of the light emitting element LD. In an example, the first semiconductor layer 11 may have a length (or thickness) longer (or thicker) than a length (or thickness) of the second semiconductor layer 13 along the length H direction of the light emitting element LD. Accordingly, the active layer 12 may be disposed closer to the second end portion EP2 (e.g., a P-type end portion) than the first end portion EP1 (e.g., an N-type end portion).

The electrode layer 14 may be disposed on the second semiconductor layer 13. For example, the electrode layer 14 may be formed (e.g., directly formed) on the second semiconductor layer 13 to be in contact with a surface (e.g., an upper surface) of the second semiconductor layer 13. In an embodiment, the electrode layer 14 and the second semiconductor layer 13 may have widths and/or surface areas, which correspond to each other, at a junction therebetween. For example, the electrode layer 14 and the second semiconductor layer 13 may have the same width and/or the same surface area at the junction therebetween, and have a section having the substantially same shape.

The electrode layer 14 may form an electrode for protecting the second semiconductor layer 13 and smoothly connecting the second semiconductor layer 13 to a certain electrode, a certain line, or the like. For example, the electrode layer 14 may be an Ohmic contact electrode or a Schottky contact electrode.

In an embodiment, the electrode layer 14 may include a metal or metal oxide. In an example, the electrode layer 14 may be formed of one or a mixture of a metal such as chromium (Cr), titanium (Ti), aluminium (Al), gold (Au), nickel (Ni) or copper (Cu), any oxide or alloy thereof, a transparent conductive material such as indium tin oxide (ITO), indium zinc oxide (IZO), indium tin zinc oxide (ITZO), zinc oxide (ZnO), or indium oxide (In₂O₃), and the like. However, this is merely illustrative, and the material of the electrode layer 14 is not limited thereto. For example, the electrode layer 14 may be formed of various conductive materials.

In an embodiment, the electrode layer 14 may be substantially transparent. Accordingly, light generated in the light emitting element LD may be emitted from the second end portion EP2 of the light emitting element LD with being transmitted through the electrode layer 14.

In an embodiment, the light emitting element LD may further include a reflective layer RML formed on a surface thereof. For example, the reflective layer RML may surround side surfaces of the first semiconductor layer 11, the active layer 12, the second semiconductor layer 13, and the electrode layer 14. The reflective layer RML may be formed on the surface of the light emitting element LD to at least surround outer circumferential surfaces of the first semiconductor layer 11, the active layer 12, the second semiconductor layer 13, and the electrode layer 14.

In an embodiment, the reflective layer RML may be a reflective electrode layer including a reflective material (e.g., a reflective metal material). For example, the reflective layer RML may include at least one of Ag, Mg, Al, Pt, Pd, Au, Ni, Nd, Ir, Cr, Li, Ca, LiF/Ca, LiF/Al, Mo, Ti, and Cu. For example, the reflective layer RML may be formed of an alloy, nitride, oxide, or the like, including at least one of Ag, Mg, Al, Pt, Pd, Au, Ni, Nd, Ir, Cr, Li, Ca, LiF/Ca, LiF/Al, Mo, Ti, and Cu, and these may be used alone or in a combination thereof. Also, the reflective layer RML may have a multi-layer structure.

As described above, by the reflective layer RML formed on the surface of the light emitting element LD in accordance with the embodiment, light generated inside the light emitting element LD (e.g., the active layer 12) may be reflected by the reflective layer RML. Thus, the light generated in the light emitting element LD may not be leaked to a side surface of the light emitting element LD but may be emitted in a light emission direction (for example, emitted to the second end portion EP2 of the light emitting element LD). Accordingly, the light emission efficiency of the light emitting element LD may be further improved.

In an embodiment, the light emitting element LD may further include an insulative film INF formed on a surface thereof. For example, the insulative film INF may be disposed to surround side surfaces of the first semiconductor layer 11, the active layer 12, the second semiconductor layer 13, and the electrode layer 14, and may surround the reflective layer RML on an outer surface of the reflective layer RML.

In the case that the insulative film INF is formed on the surface of the light emitting element LD, a short-circuit defect through the light emitting element LD may be prevented. Accordingly, the electrical stability of the light emitting element LD may be ensured. In the case that the insulative film INF is formed on the surface of the light emitting element LD, a surface defect of the light emitting element LD may be minimized, thereby improving the lifetime and efficiency of the light emitting element LD.

The insulative film INF may include an insulating material. For example, the insulative film INF may include at least one insulating material among silicon oxide (SiOₓ) (e.g., SiO₂), silicon nitride (SiNₓ) (e.g., Si₃N₄), aluminium oxide (AlₓO_{y}) (e.g., Al₂O₃), titanium oxide (TiₓO_{y}) (e.g., TiO₂), and hafnium oxide (HfOₓ), or another insulating material in addition thereto.

The insulative film INF may be formed as a single layer or a multi-layer. In an example, the insulative film INF may be formed as a double layer.

The insulative film INF may expose the first semiconductor layer 11 and the electrode layer 14 respectively at the first end portion EP1 and the second end portion EP2 of the light emitting element LD. For example, the insulative film INF may not be formed on the second end surface S2 of the light emitting element LD, and therefore, the upper surface (or the second end surface S2) of the electrode layer 14 may be exposed at the second end portion EP2 of the light emitting element LD. Accordingly, the electrode layer 14 may be connected to at least one electrode, at least one line, and/or at least one conductive pattern, thereby applying a driving power source and/or a signal to the second end portion EP2 of the light emitting element LD. Also, the insulative film INF may not be formed on the first end surface S1 of the light emitting element LD, and therefore, the lower surface (or the first end surface S1) of the first semiconductor layer 11 may be exposed at the first end portion EP1 of the light emitting element LD. Accordingly, the first semiconductor layer 11 may be connected to at least one electrode, at least one line, and/or at least one conductive pattern, thereby applying a driving power source and/or a signal to the first end portion EP1 of the light emitting element LD.

In an embodiment, the first semiconductor layer 11 may have different widths with respect to areas and/or parts thereof. For example, the first semiconductor layer 11 may have a small width and a small sectional area in an area distant from the active layer 12, as compared with an area close to the active layer 12.

For example, the first semiconductor layer 11 may include a first part 11_1 adjacent to the first end portion EP1, a second part 11_2 adjacent to the active layer 12 (or the second end portion EP2), and a third part 11_3 disposed between the first part 11_1 and the second part 11_2.

In an embodiment, the first part 11_1 and the second part 11_2 of the first semiconductor layer 11 may have the shape of a cylindrical pillar, and a width and/or a sectional area of the second part 11_2 may be greater than a width and/or a sectional area of the first part 11_1. For example, the first part 11_1 of the first semiconductor layer 11 may have an etch rate greater than an etch rate of the second part 11_2.

For example, the third part 11_3 corresponding to an intermediate area or an intermediate portion of the first semiconductor layer 11 may have a truncated cone shape. The third part 11_3 of the first semiconductor layer 11 may have different diameters (or widths) along the length H direction. For example, the diameter (or width) and the sectional area of the third part 11_3 of the first semiconductor layer 11 may become larger (or increase) as becoming closer to the top thereof (e.g., as becoming closer to the second part 11_2 from the first part 11_1) along the length H direction. In an example, the third part 11_3 of the first semiconductor layer 11 may have an inverted truncated cone shape of which sectional area increases along the length H direction.

Corresponding to the shape of the third part 11_3 of the first semiconductor layer 11, a side surface (or a line defined by the side surface) of the third part 11_3 of the first semiconductor layer 11 may have a slope inclined by an angle θ in a certain range with respect to the first end surface S1 (or the lower surface of the light emitting element LD) and/or the second end surface S2 (or the upper surface of the light emitting element LD). For example, the side surface of the third part 11_3 of the first semiconductor layer 11 may have a slope at the angle θ in a range of about 120 degrees or more with respect to the first end surface S1 and/or the second end surface S2.

As described above, the side surface of the third part 11_3 of the first semiconductor layer 11 has a slope inclined by a certain angle θ with respect to the first end surface S1 and/or the second end surface S2, and thus light generated in the light emitting element LD (e.g., light generated in the active layer 12) may be guided in a light emission direction (e.g., a direction facing the second end portion EP2 of the light emitting element LD from which light is emitted).

For example, further referring to FIGS. 3A and 3B, a light emitting element LD_C in accordance with a comparative example and advancing directions (or transmitting directions) of lights L1_C and L2_C generated from the light emitting element LD_C are illustrated in FIG. 3A, and the light emitting element LD in accordance with an embodiment and advancing directions (or transmitting directions) of lights L1 and L2 generated from the light emitting element LD are illustrated in FIG. 3B.

First, referring to FIG. 3A, the light emitting element LD_C in accordance with the comparative example may include a first semiconductor layer 11_C, an active layer 12_C, a second semiconductor layer 13_C, and an electrode layer 14_C, which are sequentially disposed in a direction (e.g., a length direction or a thickness direction). Also, the light emitting element LD_C in accordance with the comparative example may further include an insulative film INF_C formed on a surface of the light emitting element LD_C to surround outer circumferential surfaces of the first semiconductor layer 11_C, the active layer 12_C, the second semiconductor layer 13_C, and the electrode layer 14_C.

The light emitting element LD_C in accordance with the comparative example may have a cylindrical pillar shape. For example, each of the first semiconductor layer 11_C, the active layer 12_C, the second semiconductor layer 13_C, and the electrode layer 14_C of the light emitting element LD_C may have the shape of a cylindrical pillar having the same sectional area along the length direction.

At least a portion of first light L1_C advancing (or transmitting) in a light emission direction of the light emitting element LD_C (e.g., a direction facing a second end portion EP2_C as an upper direction) among the lights L1_C and L2_C generated from the active layer 12_C of the light emitting element LD_C in accordance with the comparative example may be reflected from a side surface (e.g., the insulative film INF_C) of the light emitting element LD_C to advance (or transmit) in the light emission direction of the light emitting element LD_C. For example, at least a portion of the first light L1_C may advance (or transmit) in the light emission direction with being transmitted through the side surface (e.g., the insulative film INF_C) of the light emitting element LD_C.

For example, at least a portion of second light L2_C advancing (or transmitting) in the opposite direction opposite (e.g., a direction facing a first end portion EP1_C as a lower direction) to the light emission direction of the light emitting element LD_C among the lights L1_C and L2_C generated from the active layer 12_C of the light emitting element LD_C in accordance with the comparative example may be reflected from the side surface (e.g., the insulative film INF_C) of the light emitting element LD_C to advance (or transmit) in the opposite direction of the light emission direction of the light emitting element LD_C. For example, at least a portion of the second light L2_C may advance (or transmit) in the opposite direction of the light emission direction with being transmitted through the side surface (e.g., the insulative film INF_C) of the light emitting element LD_C.

As described above, since the light emitting element LD_C in accordance with the comparative example has the shape of a cylindrical pillar, lights (e.g., the second light L2_C) advancing (or transmitting) in the opposite direction of the light emission direction among the lights L1_C and L2_C generated in the active layer 12_C are not changed to advance (or transmit) in the light emission direction, but advance (or transmit) only in the opposite direction of the light emission direction. Accordingly, in the case of the light emitting element LD_C in accordance with the comparative example, the light emission efficiency of the light emitting element LD_C may be deteriorated by loss of light generated in the active layer 12_C.

Referring to FIG. 3B, the light emitting element in accordance with an embodiment may include the first semiconductor layer 11, the active layer 12, the second semiconductor layer 13, and the electrode layer 14 as described with reference to FIGS. 1 and 2. Also, the light emitting element LD may further include the reflective layer RML and the insulative film INF.

In an embodiment, as described with reference to FIGS. 1 and 2, the light emitting element LD may have different widths with respect to areas and/or parts. For example, the diameter (e.g., the first diameter D1) of the first end surface S1 corresponding to the first end portion EP1 of the light emitting element LD and the diameter (e.g., the second diameter D2) of the second end surface S2 corresponding to the second end portion EP2 of the light emitting element LD may be different from each other, and the intermediate area and/or the intermediate portion between the first end portion EP1 and the second end portion EP2 of the light emitting element LD may have a truncated cone shape (e.g., an inverted truncated cone shape).

First light L1 advancing (or transmitting) in the light emission direction of the light emitting element LD (e.g., a direction toward the second end portion as an upper direction) among the lights L1 and L2 generated from the active layer 12 of the light emitting element LD may be reflected from a side surface (e.g., the reflective layer RML) of the light emitting element LD to advance (or transmit) in the light emission direction of the light emitting element LD.

For example, second light L2 advancing (or transmitting) in the opposite direction (e.g., a direction facing the first end portion EP1 as a lower direction) of the light emission direction of the light emitting element LD among the lights L1 and L2 generated from the active layer 12 of the light emitting element LD may be reflected from the side surface (e.g., the reflective layer RML) of the light emitting element LD, so that the advancing direction (or transmitting direction) of the second light L2 may be changed to the light emission direction (e.g., the direction facing the second end portion EP2 as the upper direction).

For example, the second light L2 generated from the active layer 12 may be reflected at a side surface PRH of the third part 11_3 having the inverted truncated cone shape in the first semiconductor layer 11 of the light emitting element LD, so that the advancing direction (or transmitting direction) of the second light L2 may be changed. In an example, as described with reference to FIGS. 1 and 2, the side surface PRH of the third part 11_3 of the first semiconductor layer 11 has a slope inclined by an angle θ in a certain range with respect to the first end surface S1 (or the lower surface of the light emitting element LD) and/or the second end surface S2 (or the upper surface of the light emitting element LD), and hence the second light L2 generated from the active layer 12 to advance (or transmit) in the direction facing the first end portion EP1 (e.g., the opposite direction of the light emission direction) may be reflected from the side surface PRH of the third part 11_3 of the first semiconductor layer 11, so that the advancing direction (or transmitting direction) of the second light L2 may be changed to the light emission direction (e.g., the direction facing the second end portion EP2 as the upper direction).

As described above, since the light emitting element LD in accordance with an embodiment includes a shape having different widths with respect to areas and/or parts, the lights L1 and L2 generated in the active layer 12 may advance (or transmit) in the light emission direction of the light emitting element LD (e.g., the direction facing the second end portion EP2 as the upper direction). Accordingly, loss of light generated in the light emitting element LD may be minimized (e.g., removed), so that the light emission efficiency of the light emitting element LD may be improved.

As the light emitting element in accordance with an embodiment includes the reflective layer RML, some of the lights L1 and L2 generated in the active layer 12 may not be transmitted from the side surface of the light emitting element LD, but most of the lights L1 and L2 may be reflected from the reflective layer RML, so that light may advance (or transmit) in the light emission direction of the light emitting element LD without being leaked to the side surface of the light emitting element LD. Accordingly, the light emission efficiency of the light emitting element LD may be further improved.

Referring back to FIGS. 1 and 2, each of the reflective layer RML and the insulative film INF may have a surface profile (or surface shape) corresponding to (or extending along) a side surface shape of the first semiconductor layer 11, the active layer 12, the second semiconductor layer 13, and the electrode layer 14. For example, each of the reflective layer RML and the insulative film INF may have a surface profile (or surface shape) corresponding to a side surface shape of the first, second, and third parts 11_1, 11_2, and 11_3 of the first semiconductor layer 11. In an example, each of the reflective layer RML and the insulative film INF may have curvatures or slopes corresponding to (or extending along) the side surface shape of the first, second, and third parts 11_1, 11_2, and 11_3 of the first semiconductor layer 11.

A light emitting device including the above-described light emitting element LD may be used in various types of devices which require a light source, including a display device and the like. For example, the light emitting element LD may be disposed in each pixel of a display panel, and be used as a light source of each pixel. However, the application field of the light emitting element LD is not limited to the above-described example. For example, the light emitting element LD may be used in other types of devices that require a light source, such as a lighting device.

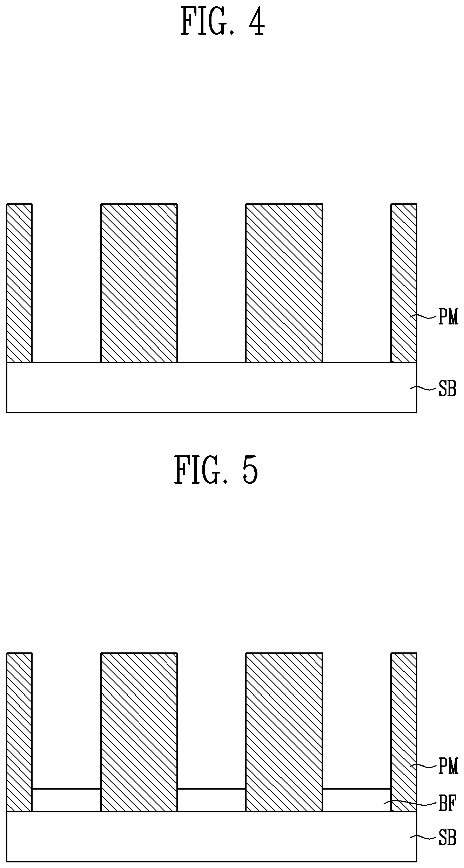

Hereinafter, a method of fabricating a light emitting element in accordance with an embodiment will be described in detail with reference to FIGS. 4 to 15.

FIGS. 4 to 15 are schematic sectional views illustrating a method of fabricating a light emitting element in accordance with an embodiment. For example, FIGS. 4 to 15 sequentially illustrate a method of fabricating the light emitting element LD in accordance with embodiments shown in FIGS. 1 and 2. In FIGS. 4 to 15, an embodiment in which a plurality of light emitting elements LD are fabricated on one second substrate BP (or backplane) is illustrated.

First, referring to FIGS. 1, 2, and 4, in the method in accordance an embodiment, a first substrate SB (or growth substrate) may be prepared (or formed).

The first substrate SB may be a substrate, a wafer or the like, which is used for fabrication suitable for an epitaxial growth process (or epitaxy) of a semiconductor. For example, the first substrate SB may be a substrate including a material such as silicon (Si), sapphire, SiC, GaN, GaAs or ZnO. For example, the first substrate SB may be various kinds of substrates and/or substrates made of various materials. In the case that an epitaxial growth process for fabricating a light emitting element LD is smoothly performed, the kind or material of the first substrate SB is not limited. After the first substrate SB is used as a substrate for an epitaxial growth process for fabricating light emitting elements LD, the first substrate SB may be finally separated from the light emitting elements LD.

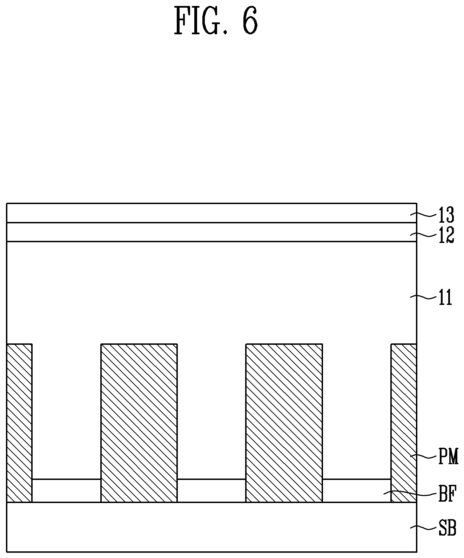

In an embodiment, in the method in accordance with an embodiment, a pattern mask PM may be provided (or formed) on the first substrate SB. The pattern mask PM may include an opening corresponding to (or overlapping) a pattern of a first semiconductor layer 11 (see FIG. 6), which is subsequently formed on the first substrate SB.

The pattern mask PM may include a silicon oxide (SiOₓ) (e.g., SiO₂), silicon nitride (SiNₓ), silicon oxynitride (SiOₓN_{y}), or another insulating material. After the pattern mask PM is used to fabricate the light emitting elements LD, the pattern mask PM may be finally separated together with the first substrate SB from the light emitting elements LD.

Referring to FIG. 5, in the method in accordance with an embodiment, a sacrificial layer BF may be provided (or formed) on the first substrate SB. In an embodiment, the sacrificial layer BF may be provided (or formed) on the first substrate SB in the opening of the pattern mask PM.

In an embodiment, the sacrificial layer BF may be formed on the first substrate SB by an epitaxial growth process, and be finally separated from the light emitting elements LD. The sacrificial layer BF may be disposed between the light emitting elements LD and the first substrate SB in a process of fabricating the light emitting elements LD, thereby allowing the light emitting elements LD and the first substrate SB to be physically spaced apart from each other.

In an embodiment, the sacrificial layer BF may include an intrinsic semiconductor layer undoped with an impurity, and the sacrificial layer BF and the first semiconductor layer 11 may include the same semiconductor material (see FIG. 6). In an embodiment, the sacrificial layer BF may include multi-layered semiconductor layers. One of the multi-layered semiconductor layers may be an intrinsic semiconductor layer. Another one of the multi-layered semiconductor layers may be a semiconductor layer doped to include a first or second conductivity type dopant, and may reduce strain between the first substrate SB and the first semiconductor layer 11.

Referring to FIG. 6, in the method in accordance with an embodiment, the first semiconductor layer 11, an active layer 12, and a second semiconductor layer 13 may be sequentially provided (or formed) on the first substrate SB. For example, in the method in accordance with an embodiment, the first semiconductor layer 11, the active layer 12, and the second semiconductor layer 13 may be sequentially formed on the first substrate SB on which the sacrificial layer BF is formed by an epitaxial growth process.

The first semiconductor layer 11 may be formed of the material of the first semiconductor layer 11, which is described in the embodiments shown in FIGS. 1 and 2, or another semiconductor material. The first semiconductor layer 11 may be doped to include an N-type dopant such as Si, Ge or Sn.

The first semiconductor layer 11 may be formed by an epitaxial growth process by using a process technique such as Metal-Organic Vapor Phase Epitaxy (MOVPE), Metal-Organic Chemical Vapor Deposition (MOCVD), Molecular Beam Epitaxy (MBE), Liquid Phase Epitaxy (LPE), or Vapor Phase Epitaxy (VPE). However, this is merely illustrative, and the method of forming the first semiconductor layer 11 is not limited thereto.

In an embodiment, a portion of the first semiconductor layer 11 may be provided (or formed) in the opening of the pattern mask PM on the first substrate SB. The portion of the first semiconductor layer 11 provided (or formed) in the opening of the pattern mask PM may include the first part 11_1 of the first semiconductor layer 11 described with reference to FIGS. 1 and 2.

The active layer 12 may be formed of the material of the active layer 12, which is described in the embodiments shown in FIGS. 1 and 2, or another semiconductor material. In an embodiment, the active layer 12 may be formed by an epitaxial growth process by using a process technique such as MOVPE, MOCVD, MBE, LPE or VPE. However, this is merely illustrative, and the method of forming the active layer 12 is not limited thereto.

The second semiconductor layer 13 may be formed of the material of the second semiconductor layer 13, which is described in the embodiments shown in FIGS. 1 and 2, or another semiconductor material. The second semiconductor layer 13 may be doped to include a P-type dopant such as Mg. In an embodiment, the second semiconductor layer 13 may be formed by an epitaxial growth process by using a process technique such as MOVPE, MOCVD, MBE, LPE or VPE. However, this is merely illustrative, and the method of forming the second semiconductor layer 13 is not limited thereto.

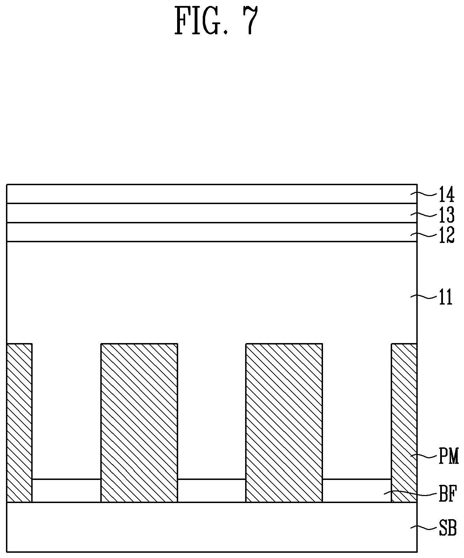

Referring to FIG. 7, in the method in accordance with an embodiment, an electrode layer 14 may be provided (or formed) on the second semiconductor layer 13. For example, the electrode layer 14 may be formed (e.g., entirely formed) on a surface (e.g., an upper surface) of the first substrate SB on which the first semiconductor layer 11, the active layer 12, and the second semiconductor layer 13 are sequentially provided (or formed).

In an embodiment, the electrode layer 14 may be formed of the material of the electrode layer 14, which is described in the embodiments shown in FIGS. 1 and 2, or another conductive material.

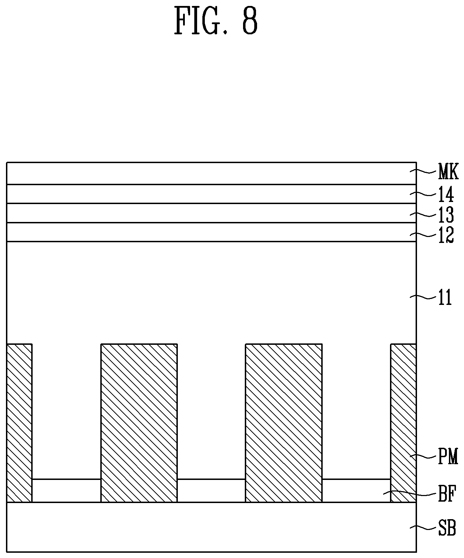

Referring to FIGS. 8 to 10, in the method in accordance with an embodiment, the first semiconductor layer 11, the active layer 12, the second semiconductor layer 13, and the electrode layer 14 may be etched in a direction substantially vertical to the first substrate SB, thereby patterning a multi-layered first stack structure (also referred to as a "first light emitting stack member" or a "first light emitting core") including the first semiconductor layer 11, the active layer 12, the second semiconductor layer 13, and the electrode layer 14.

In an embodiment, in the method in accordance with an embodiment, the light emitting element LD may be primarily patterned by a patterning process by using a nano imprint lithography process technique, a photolithography process technique, or the like. For example, in the method in accordance with an embodiment, the light emitting element LD may be primarily patterned by the nano imprint lithography process technique.

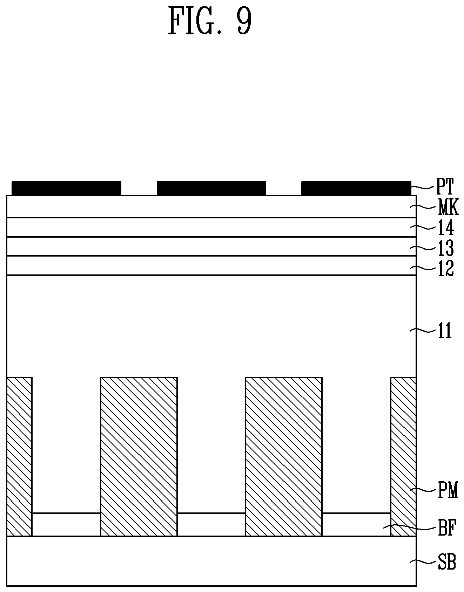

For example, in the method in accordance with an embodiment, after a mask layer MK is formed on the electrode layer 14 as shown in FIG. 8, etching pattern layers PT (e.g., nano patterns) may be formed on the mask layer MK as shown in FIG. 9. Subsequently, in the method in accordance with an embodiment, the first semiconductor layer 11, the active layer 12, the second semiconductor layer 13, and the electrode layer 14 may be etched in a certain form by an etching process by using the mask layer MK and the etching pattern layers PT, thereby forming (or generating) the first stack structure (or the first light emitting stack member, or the first light emitting core).

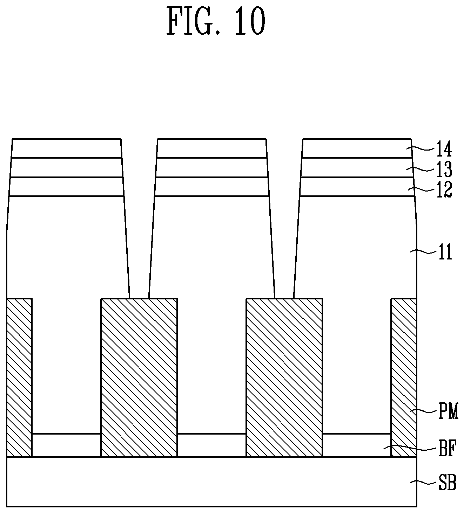

For example, in the method in accordance with an embodiment, the first semiconductor layer 11, the active layer 12, the second semiconductor layer 13, and the electrode layer 14 may be etched in a vertical direction by performing a dry etching process (or first etching process), by using the mask layer MK and the etching pattern layers PT, so that the first stack structure including the first semiconductor layer 11, the active layer 12, the second semiconductor layer 13, and the electrode layer 14 may be formed (or generated) as shown in FIG. 10.

In an embodiment, the mask layer MK may include at least two mask layers formed of different materials for the purpose of selective dry etching for each layer and/or each film, which is performed in a subsequent process. For example, the mask layer MK may include a first mask layer (e.g., a first hard mask layer) which is formed on the electrode layer 14 and includes an insulating material and a second mask layer (e.g., a second hard mask layer) which is formed on the first mask layer and includes a conductive material. However, this is merely illustrative, and embodiments are not limited thereto.

The etching pattern layers PT may be disposed on the mask layer MK to be spaced apart from each other. The etching pattern layers PT may be formed with a shape, a size, and/or a distance, which correspond to the light emitting elements LD, so as to pattern each of the light emitting elements LD on the first substrate SB. For example, the etching pattern layers PT may have a shape or a size corresponding to a shape and a diameter (e.g., the second diameter D2 at the second end portion EP2 of the light emitting element LD described with reference to FIGS. 1 and 2) of light emitting elements LD to be fabricated, and be spaced apart from each other at a distance to a degree to which the light emitting elements LD may be readily separated from each other.

The etching pattern layers PT may include polymer or another material. In an embodiment, the etching pattern layers PT may include a nano imprint resin, and be formed by a nano imprint lithography process technique.

In an embodiment, in the method in accordance with an embodiment, the first semiconductor layer 11, the active layer 12, the second semiconductor layer 13, and the electrode layer 14 may be primarily etched by a stepwise dry etching process by using the etching pattern layers PT. For example, in the method in accordance with an embodiment, after the mask layer MK is first etched by using the etching pattern layers PT, the electrode layer 14, the second semiconductor layer 13, the active layer 12, and the first semiconductor layer 11 may be continuously etched. In an embodiment, the electrode layer 14, the second semiconductor layer 13, the active layer 12, and the first semiconductor layer 11 may be etched in the direction substantially vertical to the first substrate SB by the dry etching process, to have an approximately rod shape as shown in FIG. 10. As shown in FIG. 10, after the dry etching process on the electrode layer 14, the second semiconductor layer 13, the active layer 12, and the first semiconductor layer 11 may be completed, the mask layer MK and the etching pattern layers PT may be removed.

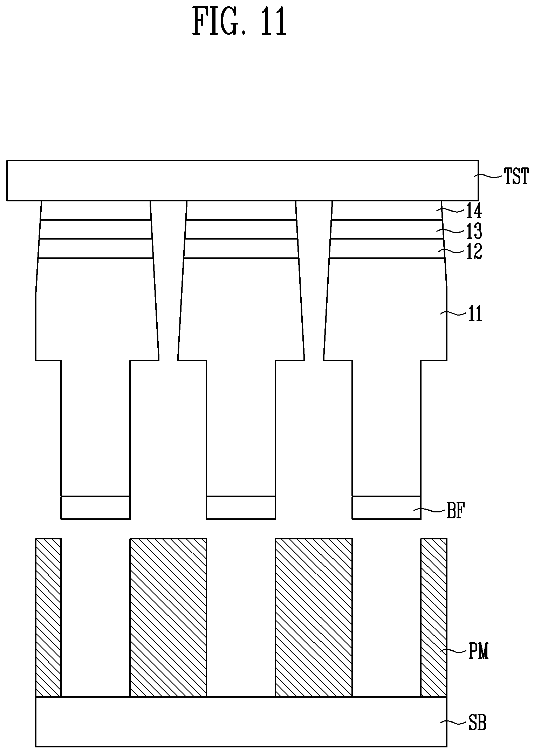

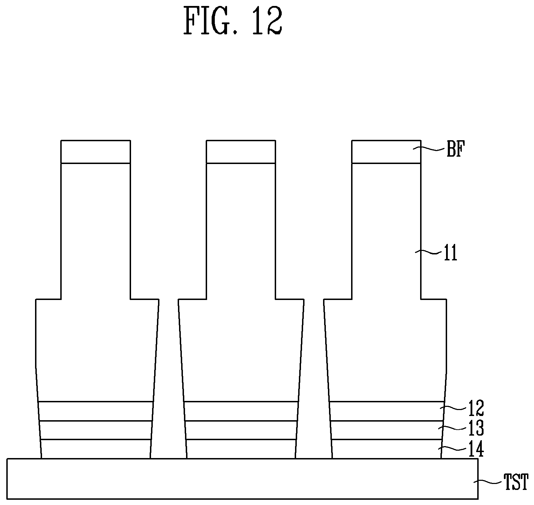

Referring to FIGS. 11 and 12, in the method in accordance with an embodiment, the first stack structure including the first semiconductor layer 11, the active layer 12, the second semiconductor layer 13, and the electrode layer 14 and the sacrificial layer BF may be separated from the first substrate SB. For example, in the method in accordance with an embodiment, the first stack structure including the first semiconductor layer 11, the active layer 12, the second semiconductor layer 13, and the electrode layer 14 and the sacrificial layer BF may be separated by using a transfer base TST. For example, the transfer base TST may include a stretchable material in some embodiments, and further include an adhesive layer for attaching the first stack structure (e.g., the electrode layer 14) thereto.

In an embodiment, in the method in accordance with an embodiment, the sacrificial layer BF may be separated from the first substrate SB by an electrical etching process and/or a chemical etching process, or another process. For example, the sacrificial layer BF and the first substrate SB may be separated from each other by a Laser Lift-Off (LLO) process. However, this is merely illustrative. In some embodiments, the sacrificial layer BF and the first substrate SB may be separated from each other by a Chemical Lift-Off (CLO) process.

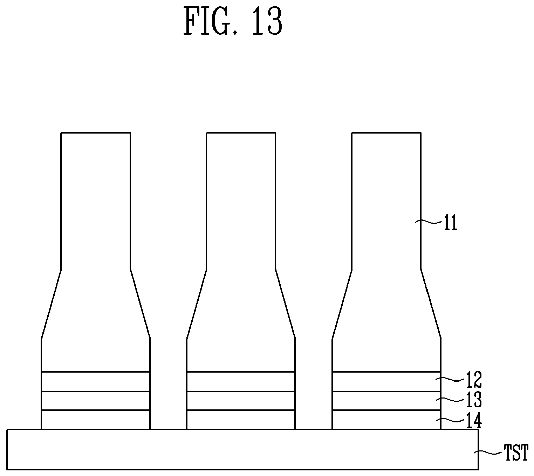

Referring to FIG. 13, in the method in accordance with an embodiment, the first stack structure including the first semiconductor layer 11, the active layer 12, the second semiconductor layer 13, and the electrode layer 14 and the sacrificial layer BF may be separated from each other. In an embodiment, the sacrificial layer BF may be separated from the first stack structure by an electrical etching process and/or a chemical etching process, or another process. For example, the sacrificial layer BF may be separated from the first stack structure by an etch-back process by using different etch rates.

Subsequently, in the method in accordance with an embodiment, a second stack structure may be formed (or generated) by etching each first stack structure etched primarily in a certain shape by an additional etching process as shown in FIG. 13.

For example, in the method in accordance with an embodiment, the first semiconductor layer 11, the active layer 12, the second semiconductor layer 13, and the electrode layer 14 may be etched by an additional etching process such as a wet etching process (or second etching process), thereby forming (or generating) a multi-layered second stack structure (also referred to as a "second light emitting stack member" or a "second light emitting core") including the first semiconductor layer 11, the active layer 12, the second semiconductor layer 13, and the electrode layer 14. For example, in the method in accordance with an embodiment, the first semiconductor layer 11, the active layer 12, the second semiconductor layer 13, and the electrode layer 14 may be continuously etched by a wet etching process. The second stack structure may form a light emitting stack member (or light emitting core) of the light emitting element LD in accordance with an embodiment.

In an embodiment, as shown in FIG. 13, the second stack structure (or the second light emitting stack member, or the second light emitting core) including the first semiconductor layer 11, the active layer 12, the second semiconductor layer 13, and the electrode layer 14, patterned by an additional etching process, may have different widths with respect to areas and/or portions. For example, as described with reference to FIGS. 1 and 2, an intermediate area and/or an intermediate portion between end portions (e.g., opposite end portions) of the second stack structure of the light emitting stack structure of the light emitting element LD may have a truncated cone shape.

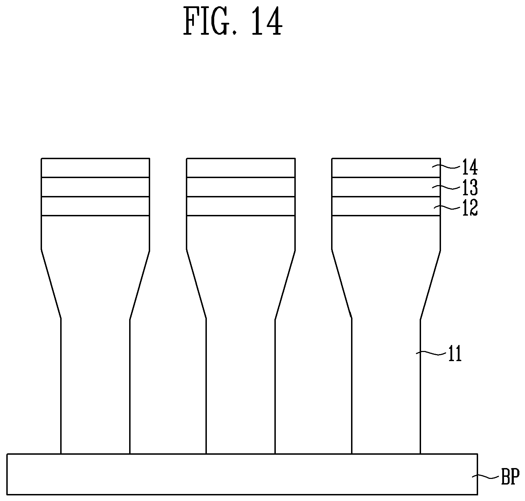

Referring to FIG. 14, in the method in accordance with an embodiment, the second stack structure (or the second light emitting stack member, or the second light emitting core) including the first semiconductor layer 11, the active layer 12, the second semiconductor layer 13, and the electrode layer 14 may be attached onto a second substrate BP (or backplane). For example, the second stack structure (or the second light emitting stack member, or the second light emitting core) including the first semiconductor layer 11, the active layer 12, the second semiconductor layer 13, and the electrode layer 14 may be attached onto the second substrate BP by a bonding process or the like.

For example, after the light emitting stack member (or light emitting core) of the light emitting element LD in accordance with an embodiment is formed on a separate growth substrate (e.g., the first substrate SB) and is partially patterned (e.g., patterned by a dry etching process), the light emitting stack member (or light emitting core) of the light emitting element LD in accordance with an embodiment may be separated from the growth substrate to be transferred through the transfer base TST, and patterned (e.g., patterned by a wet etching process) in a certain shape to be attached onto a backplane (e.g., the second substrate BP).

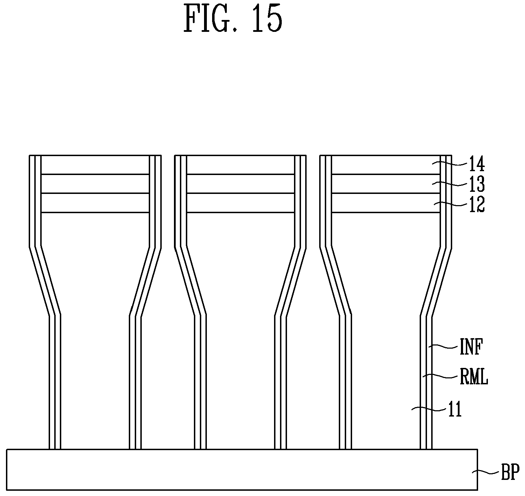

Referring to FIG. 15, in the method in accordance with an embodiment, a reflective layer RML may be provided (or formed) on a side surface of the second stack structure (or the second light emitting stack member, or the second light emitting core) including the first semiconductor layer 11, the active layer 12, the second semiconductor layer 13, and the electrode layer 14, and an insulative film INF may be provided (or formed) on the reflective layer RML. The reflective layer RML may be formed of the material, which is described in the embodiments shown in FIGS. 1 and 2, or another conductive material. For example, the insulative film INF may be formed of the material, which is described in the embodiments shown in FIGS. 1 and 2, or another conductive material. For example, the insulative film INF may be formed by an Atomic Layer Deposition (ALD) process, a sol-gel process, a chemical deposition process (e.g., Plasma Enhanced Chemical Vapor Deposition (PECVD)), or the like. However, this is merely illustrative, and embodiments are not limited thereto. For example, the insulative film INF may be formed on a surface (e.g., an upper surface) of the electrode layer 14 and removed by a separate process (e.g., an etching process). Accordingly, the electrode layer 14 may be exposed at a surface (e.g., an upper surface) of the light emitting stack member (or light emitting core) of each light emitting element LD.

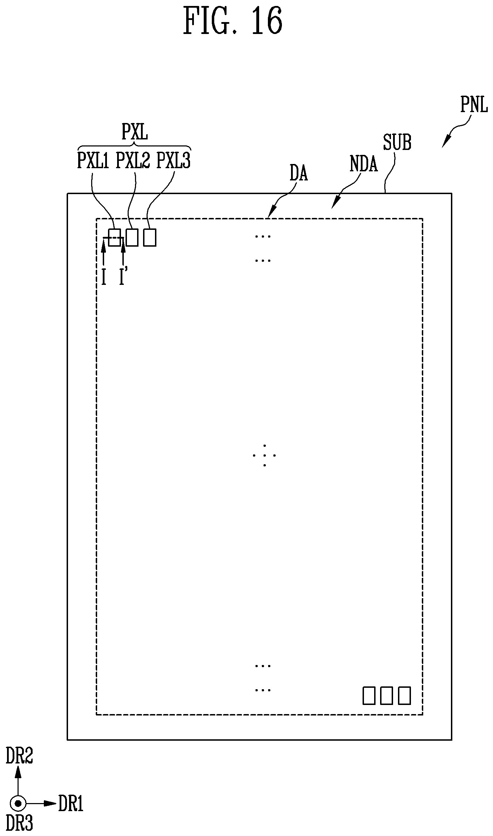

FIG. 16 is a schematic plan view illustrating a display device in accordance with an embodiment.

In FIG. 16, a display device, e.g., a display panel PNL formed in the display device will be illustrated as an example of an electronic device which uses, as a light source, the light emitting element LD in accordance with an embodiment, which is described with reference to FIGS. 1 and 2.

In FIG. 16, a structure of the display panel PNL will be illustrated based on a display area DA. However, in some embodiments, at least one driving circuit (e.g., at least one of a scan driver and a data driver), lines, and/or pads may be further disposed in the display panel PNL.

Referring to FIG. 16, the display panel PNL may include a substrate SUB and a pixel PXL disposed on the substrate SUB. The pixel PXL may be formed in plurality on the substrate SUB.

The substrate SUB may be used to form a base member of the display panel PNL, and may be a rigid or flexible substrate or a rigid or flexible film.

The display panel PNL and the substrate SUB for forming the display panel PNL may include the display area DA to display an image and a non-display area NDA except for the display area DA.

The pixel PXL may be disposed in the display area DA. The pixel PXL may include a light emitting element LD. Various lines, pads, and/or a built-in circuit, which are connected to the pixels PXL of the display area DA, may be disposed in the non-display area NDA. In some embodiments, the pixels PXL may be arranged in the display area DA in various structures and/or various manners.

In some embodiments, two or more kinds of pixels PXL emitting lights of different colors may be disposed (or formed) in the display area DA. In an example, the pixel PXL may include a first pixel PXL1 emitting light of a first color, a second pixel PXL2 emitting light of a second color, and a third pixel PXL3 emitting light of a third color. At least one first pixel PXL1, at least one second pixel PXL2, and at least one third pixel PXL3, which are disposed adjacent to each other, may form a pixel unit capable of emitting lights of various colors. For example, each of the first, second, and third pixels PXL1, PXL2, and PXL3 may be a sub-pixel emitting light of a certain color. In some embodiments, the first pixel PXL1 may be a red pixel to emit red light, the second pixel PXL2 may be a green pixel to emit green light, and the third pixel PXL3 may be a blue pixel to emit blue light. However, embodiments are not limited thereto.

In an embodiment, the first pixel PXL1, the second pixel PXL2, and the third pixel PXL3 may have, as light sources, a light emitting element of a first color, a light emitting element of a second color, and a light emitting element of a third color, to emit light of the first color, light of the second color, and light of the third color, respectively. In another example, the first pixel PXL1, the second pixel PXL2, and the third pixel PXL3 may have light emitting elements emitting light of the same color, and may include color conversion layers and/or color filters of different colors, which are disposed on the respective light emitting elements, to respectively emit light of the first color, light of the second color, and light of the third color. However, the color, kind, and/or number of pixels PXL of each pixel unit are not limited. For example, the color of light emitted by each pixel PXL may be variously changed.

The pixel PXL may include at least one light source driven by a certain control signal (e.g., a scan signal and a data signal) and/or a certain power source (e.g., a first power source and a second power source). In an embodiment, each pixel PXL may be formed as an active pixel. However, the kind, structure, and/or driving method of pixels PXL which is applied to the display device are not limited. For example, each pixel PXL may be formed as a pixel of a passive or active light emitting display device using various structures and/or driving methods.

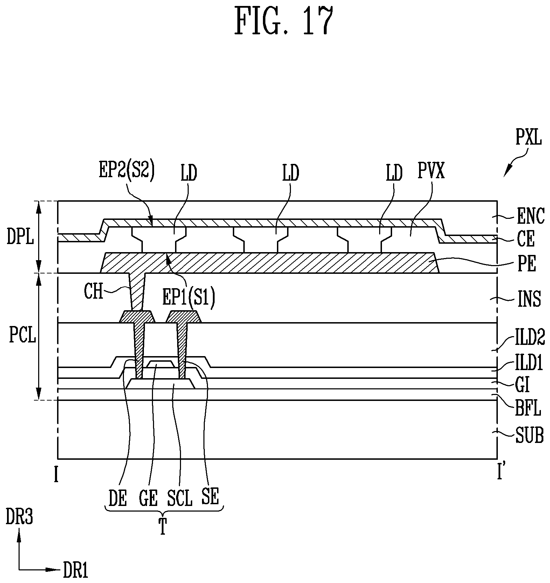

FIG. 17 is a schematic sectional view taken along line I-I' shown in FIG. 16. In FIG. 17, a structure of the pixel PXL included in the display panel PNL shown in FIG. 16 is schematically illustrated.

Referring to FIGS. 1, 2, 16, and 17, the pixel PXL may include a substrate SUB, a pixel circuit layer PCL, and a display element layer DPL.

The substrate SUB may be a rigid or flexible substrate. In an example, the substrate SUB may include a rigid or flexible material. In an example, the flexible material may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate. However, this is merely illustrative, and the material included in the substrate SUB is not limited thereto.

The pixel circuit layer PCL may be disposed on the substrate SUB. The pixel circuit layer PCL may include a buffer layer BFL, a transistor T, a gate insulating layer GI, a first interlayer insulating layer ILD1, a second interlayer insulating layer ILD2, a contact hole CH, and an insulating layer INS.

The buffer layer BFL may be disposed on the substrate SUB. The buffer layer BFL may prevent an impurity from being diffused (or permeating) from the outside. The buffer layer BFL may include at least one of silicon nitride (SiNₓ), silicon oxide (SiOₓ), silicon oxynitride (SiOₓN_{y}), and a metal oxide such as aluminium oxide (AlOₓ).

The transistor T may be a thin film transistor. In an example, the transistor T may be a driving transistor among thin film transistors. The transistor T may include a semiconductor layer SCL, a gate electrode GE, a source electrode SE, and a drain electrode DE.

The semiconductor layer SCL may be disposed on the buffer layer BFL. The semiconductor layer SCL may include at least one of poly-silicon, amorphous silicon, and an oxide semiconductor.

The semiconductor layer SCL may include a first contact region in contact with the source electrode SE and a second contact region in contact with the drain electrode DE.

The first contact region and the second contact region may correspond to a semiconductor pattern layer doped with an impurity. A region between the first contact region and the second contact region may be a channel region. The channel region may correspond to an intrinsic semiconductor pattern layer undoped with the impurity.

The gate insulating layer GI may be formed over the semiconductor layer SCL. The gate insulating layer GI may include an inorganic material. In an example, the gate insulating layer GI may include at least one of silicon nitride (SiNₓ), silicon oxide (SiOₓ), silicon oxynitride (SiOₓN_{y}), and aluminium oxide (AlOₓ). In some embodiments, the gate insulating layer GI may include an organic material.

The gate electrode GE may be disposed on the gate insulating layer GI. The position of the gate electrode GE may correspond to the position of the channel region of the semiconductor layer SCL. For example, the gate electrode GE may be disposed on the channel region of the semiconductor layer SCL with the gate insulating layer GI disposed therebetween.

The first interlayer insulating layer ILD1 may be disposed over the gate electrode GE. Like the gate insulating layer GI, the first interlayer insulating layer ILD1 may include at least one of silicon nitride (SiNₓ), silicon oxide (SiOₓ), silicon oxynitride (SiOₓN_{y}), and aluminium oxide (AlOₓ).

The source electrode SE and the drain electrode DE may be disposed on the first interlayer insulating layer ILD1. The source electrode SE may be in contact with the first contact region of the semiconductor layer SCL by penetrating the gate insulating layer GI and the first interlayer insulating layer ILD1, and the drain electrode DE may be in contact with the second contact region of the semiconductor layer SCL by penetrating the gate insulating layer GI and the first interlayer insulating layer ILD1.

The second interlayer insulating layer ILD2 may be disposed over the source electrode SE and the drain electrode DE. Like the first interlayer insulating layer ILD1 and the gate insulating layer GI, the second interlayer insulating layer ILD2 may include an inorganic material. The inorganic material may include at least one of the materials exemplified as the material of the first interlayer insulating layer ILD1 and the gate insulating layer GI, e.g., silicon nitride (SiNₓ), silicon oxide (SiOₓ), silicon oxynitride (SiOₓN_{y}), and aluminium oxide (AlOₓ). In some embodiments, the second interlayer insulating layer ILD2 may include an organic material.

The insulating layer INS may have a form including an organic insulating layer, an inorganic insulating layer, or the organic insulating layer disposed on the inorganic insulating layer.

The insulating layer INS may include the contact hole CH connected (e.g., electrically connected) to a region of the drain electrode DE.

The display element layer DPL may be disposed on the pixel circuit layer PCL. The display element layer DPL may include a pixel electrode PE, a light emitting element LD, a connection electrode CE, a protective layer PVX, and an encapsulation layer ENC.

The pixel electrode PE (or first electrode) may be disposed on the insulating layer INS. The pixel electrode PE may be an anode electrode. The pixel electrode PE may at least include a conductive material. In an example, the pixel electrode PE may include a copper (Cu), gold (Au), silver (Ag), magnesium (Mg), aluminium (Al), platinum (Pt), lead (Pb), nickel (Ni), neodymium (Nd), iridium (Ir), chromium (Cr), lithium (Li), calcium (Ca), or any mixture thereof, and indium tin oxide (ITO), indium zinc oxide (IZO), zinc oxide (ZnO), and indium oxide (In₂O₃). However, embodiments are not limited thereto.

At least a portion of the connection electrode CE (or second electrode) may be disposed on the protective layer PVX, and at least another portion of the connection electrode CE may be connected (e.g., electrically connected) to an end portion of the light emitting element LD. The connection electrode CE may be formed in a plate shape on the display area DA, but embodiments are not limited thereto. The connection electrode CE may include a transparent conductive material (or substance) such as one transparent conductive oxide among Indium Tin Oxide (ITO), Indium Zinc Oxide (IZO), Aluminium Zinc Oxide (AZO), Gallium doped Zinc Oxide (GZO), Zinc Tin Oxide (ZTO), Gallium Tin Oxide (GTO), and Fluorine doped Tin Oxide (FTO). In some embodiments, the connection electrode CE may include a translucent conductive material (or substance) such as magnesium (Mg), silver (Ag), or an alloy of magnesium (Mg) and silver (Ag).

An electrical signal flowing along a third direction DR3 may be provided between the pixel electrode PE and the connection electrode CE. In the case that the electrical signal is provided, the light emitting element LD may emit light. For example, an electrical signal may flow in a direction facing a second end portion EP2 from a first end portion EP1 or a direction facing the first end portion EP1 from the second end portion EP2 in the light emitting element LD. The direction in which the electrical signal flows may be vertical to the periphery of the substrate SUB.

A polarity of the pixel electrode PE and a polarity of the connection electrode CE may be different from each other. In the case that the pixel electrode PE is a cathode electrode, the connection electrode CE may be the anode electrode. In the case that the pixel electrode PE is the anode electrode, the connection electrode CE may be the cathode electrode. Hereinafter, a case where the pixel electrode PE is the anode electrode and the connection electrode CE is the cathode electrode is described.

The pixel electrode PE and the connection electrode CE may be spaced apart from each other. The pixel electrode PE may be connected (e.g., electrically connected) to the contact hole CH, to provide an electrical signal provided from the transistor T to the light emitting element LD.

In the case that an electrical signal is provided, the light emitting element LD may emit light. The light emitting element LD may emit light along the third direction DR3. The light emitting element LD may be arranged on the pixel electrode PE. Light emitting elements LD may be arranged such that the first end portion EP1 may face the pixel electrode PE. The light emitting elements LD may be arranged such that the second end portion EP2 of the light emitting element LD may face the connection electrode CE. The first end portion EP1 of the light emitting element LD may be connected (e.g., electrically connected) to the pixel electrode PE, and the second end portion EP2 of the light emitting element LD may be connected (e.g., electrically connected) to the connection electrode CE. For example, a first semiconductor layer 11 of the light emitting element LD may be connected (e.g., electrically connected) to the pixel electrode PE, and a second semiconductor layer 13 (or an electrode layer 14) of the light emitting element LD may be connected (e.g., electrically connected) to the connection electrode CE.

At least a portion of a first end surface S1 (e.g., a lower surface) of the light emitting element LD may be in contact with (e.g., physically in contact with) the pixel electrode PE. At least a portion of a second end surface S2 (e.g., an upper surface) of the light emitting element LD may be in contact with (e.g., physically in contact with) the connection electrode CE.

An area of the light emitting element LD in contact with the pixel electrode PE may be smaller than an area of the light emitting element LD in contact with the connection electrode CE. For example, the first end surface S1 of the light emitting element LD may be connected to the pixel electrode PE, so that a certain contact area may be formed. The second end surface S2 of the light emitting element LD may be connected to the connection electrode CE, so that a contact area greater than the certain contact area may be formed.

The protective layer PVX may surround the light emitting elements LD. The protective layer PVX may remove a step difference caused by the light emitting element LD and the like. The protective layer PVX may include an organic insulating material such as acryl resin, epoxy resin, phenolic resin, polyamides resin, polyimides resin, unsaturated polyesters resin, poly-phenylene ethers resin, poly-phenylene sulfides resin, or benzocyclobutene (BCB). However, embodiments are not limited thereto.

The encapsulation layer ENC may be disposed on the connection electrode CE. The encapsulation layer ENC may be disposed at an outer portion of the display element layer DPL, thereby planarizing an individual component. The encapsulation layer ENC may include an organic material or an inorganic material, but is not limited to a specific material.

In accordance with the embodiments, the light emitting element LD may have different widths (e.g., diameters D1 and D2) with respect to areas and/or parts. For example, the first semiconductor layer 11 included in the light emitting element LD may include a first part 11_1, a second part 11_2, and a third part 11_3 between the first part 11_1 and the second part 11_2, and the third part 11_3 may have an inverted truncated cone shape.

A side surface of the third part 11_3 may have a certain angle with respect to a surface (e.g., an upper surface and/or a lower surface) corresponding to end portions (e.g., opposite end portions) of the light emitting element LD, so that light generated from the active layer included in the light emitting element LD may be guided in the light emission direction. Accordingly, the light emission efficiency of the light emitting element LD may be improved.

In concluding the detailed description, those skilled in the art will appreciate that many variations and modifications may be made to the embodiments without substantially departing from the principles and spirit and scope of the disclosure. Therefore, the disclosed embodiments are used in a generic and descriptive sense only and not for purposes of limitation.

## Claims

1. A light emitting element comprising:
a first end surface and a second end surface opposite to each other;
a first semiconductor layer disposed at the first end surface;
an active layer disposed on the first semiconductor layer;
a second semiconductor layer disposed on the active layer; and
an electrode layer disposed on the second semiconductor layer and disposed at the second end surface, wherein
the first semiconductor layer includes:
a first part,
a second part disposed on the first part and adjacent to the active layer, and
a third part disposed between the first part and the second part,
a width of the first part and a width of the second part are different from each other, and
the third part has different widths at different length positions.

2. The light emitting element of claim 1, wherein
each of the first part and the second part of the first semiconductor layer has a cylindrical pillar shape, and
the width of the second part is greater than the width of the first part.

3. The light emitting element of claim 2, wherein the width of the third part of the first semiconductor layer increases as becoming closer to the second part from the first part.

4. The light emitting element of claim 3, wherein the third part of the first semiconductor layer has a truncated cone shape.

5. The light emitting element of claim 3, wherein a side surface of the third part has a slope at an angle with respect to the first end surface of the light emitting element.

6. The light emitting element of claim 5, wherein the angle is in a range of about 120 degrees or more.

7. The light emitting element of claim 2, wherein each of the active layer, the second semiconductor layer, and the electrode layer has a cylindrical pillar shape.

8. The light emitting element of claim 7, wherein a width of the active layer, a width of the second semiconductor layer, a width of the electrode layer, and the width of the second part of the first semiconductor layer are substantially same as each other.

9. The light emitting element of claim 1, further comprising:
a reflective layer surrounding a side surface of the first semiconductor layer, a side surface of the active layer, a side surface of the second semiconductor layer, and a side surface of the electrode layer.

10. The light emitting element of claim 9, wherein the reflective layer includes a reflective metal material.

11. The light emitting element of claim 1, further comprising:
an insulative film surrounding a side surface of the first semiconductor layer, a side surface of the active layer, a side surface of the second semiconductor layer, and a side surface of the electrode layer.

12. The light emitting element of claim 11, wherein the insulative film exposes the first end surface of the light emitting element as a lower surface of the first semiconductor layer, and exposes the second end surface of the light emitting element as an upper surface of the electrode layer.

13. A display device comprising:
a pixel including:
a first electrode,
a second electrode, and
a light emitting element including:
a first end surface electrically connected to the first electrode and
a second end surface electrically connected to the second electrode, wherein
the light emitting element includes:
a first semiconductor layer disposed at the first end surface;
an active layer disposed on the first semiconductor layer;
a second semiconductor layer disposed on the active layer; and
an electrode layer disposed on the second semiconductor layer and disposed at the second end surface,
the first semiconductor layer includes:
a first part,
a second part disposed on the first part and adjacent to the active layer, and
a third part disposed between the first part and the second part,
a width of the first part and a width of the second part are different from each other, and
the third part has different widths at different length positions.

14. The display device of claim 13, wherein
each of the first part and the second part of the first semiconductor layer has a cylindrical pillar shape, and
the width of the second part is greater than the width of the first part.

15. The display device of claim 14, wherein the width of the third part of the first semiconductor layer increases as becoming closer to the second part from the first part.

16. A method of fabricating a light emitting element, the method comprising:
forming a pattern mask on a first substrate;
sequentially forming a first semiconductor layer, an active layer, a second semiconductor layer, and an electrode layer on the first substrate on which the pattern mask is formed;
sequentially forming a mask layer and an etching pattern layer on the electrode layer;
forming a first light emitting stack member by patterning at least a portion of each of the first semiconductor layer, the active layer, the second semiconductor layer, and the electrode layer in a direction facing the first semiconductor layer from the electrode layer by a first etching process by using the mask layer and the etching pattern layer;
separating the first light emitting stack member from the first substrate;
forming a second light emitting stack member by patterning a side surface of the first semiconductor layer, a side surface of the active layer, a side surface of the second semiconductor layer, and a side surface of the electrode layer in a direction facing the electrode layer from the first semiconductor layer by a second etching process of patterning at least a portion of the first light emitting stack member; and
attaching the second light emitting stack member to a second substrate.

17. The method of claim 16, wherein the forming of the second light emitting stack member includes etching the first semiconductor layer such that at least a portion of the first semiconductor layer has different widths at different length positions.

18. The method of claim 16, further comprising:
forming a reflective layer on the side surface of the first semiconductor layer, the side surface of the active layer, the side surface of the second semiconductor layer, and the side surface of the electrode layer of the second light emitting stack member.

19. The method of claim 16, further comprising:
forming an insulative film on the side surface of the first semiconductor layer, the side surface of the active layer, the side surface of the second semiconductor layer, and the side surface of the electrode layer of the second light emitting stack member.

20. The method of claim 16, wherein
the first etching process is a dry etching process, and
the second etching process is a wet etching process.
